# EUROPEAN PATENT APPLICATION

(11) **EP 4 607 586 A1**
(43) Date of publication of application: **27.08.2025**
(21) Application number: 24159392.0
(22) Date of filing: 23.02.2024
(51) Int. Cl.: H01L 23/48

(54) **METHOD AND SYSTEM FOR CONNECTING A TERMINAL ELEMENT TO A SUBSTRATE**

(71) Applicant: Infineon Technologies AG, 85579 Neubiberg (DE)
(72) Inventor: TROSKA, Georg, 58730 Fröndenberg/ Ruhr (DE)
(74) Representative: Westphal, Mussgnug & Partner, Patentanwälte mbB

(57) **Abstract**

A method comprises feeding a continuous wire comprising a plurality of segments arranged successively to form the continuous wire into a first end of a channel and further through the channel formed in a sonotrode of a welding tool until a first end of the continuous wire protrudes from a second end of the channel opposite the first end of the channel, welding the first end of the continuous wire to a substrate by means of the sonotrode, and cutting off a first segment from the continuous wire, the first segment comprising a first section comprising the first end, and a second section directly adjoining and extending from the first section, wherein at least during the step of welding the first end of the continuous wire to the substrate, a hardness of the second section is greater than a hardness of the first section.

## Description

### TECHNICAL FIELD

The instant disclosure relates to methods and systems for connecting terminal elements to a substrate, in particular to terminal elements for semiconductor modules.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

The semiconductor substrate and the elements mounted thereon are usually electrically coupled to the outside of the housing by means of terminal elements. Such terminal elements are mechanically and electrically coupled to the substrate or to one or more of the elements mounted thereon with a first end, and from there extend through the housing to the outside of the housing. Terminal elements are often coupled to the substrate or to other components of the power semiconductor module arrangement by means of soldering, sintering or welding techniques. The resulting connections should be stable, and the method that is used to form the connections should be swift, reliable, cost-effective and implementable in a space saving way.

There is a need for a method and a system for connecting a terminal element to a substrate in a swift, reliable, cost-effective and space saving way.

### SUMMARY

A method includes feeding a continuous wire including a plurality of segments arranged successively to form the continuous wire into a first end of a channel and further through the channel formed in a sonotrode of a welding tool until a first end of the continuous wire protrudes from a second end of the channel opposite the first end of the channel, welding the first end of the continuous wire to a substrate by means of the sonotrode, and cutting off a first segment from the continuous wire, the first segment including a first section including the first end, and a second section directly adjoining and extending from the first section, wherein at least during the step of welding the first end of the continuous wire to the substrate, a hardness of the second section is greater than a hardness of the first section.

A system includes a sonotrode with a channel formed therethrough, and a cutting tool, wherein the system is configured to feed a continuous wire including a plurality of segments arranged successively to form the continuous wire into a first end of the channel and further through the channel formed in the sonotrode until a first end of the continuous wire protrudes from a second end of the channel opposite the first end of the channel, weld the first end of the continuous wire to a substrate by means of the sonotrode, and cut off a first segment from the continuous wire, the first segment including a first section including the first end, and a second section directly adjoining and extending from the first section, wherein, at least during the step of welding the first end of the continuous wire to the substrate, a hardness of the second section is greater than a hardness of the first section.

A continuous wire includes a plurality of segments arranged successively to form the continuous wire, wherein each of the plurality of segments includes a first section and a second section directly adjoining and extending from the first section, wherein the second section of each segment further directly adjoins the first section of a directly successive segment, for each segment of the plurality of segments, a hardness of the second section is greater than a hardness of the first section, and the first section of each of the plurality of segments is configured to be attached to a substrate of a semiconductor module.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a three-dimensional view of a power semiconductor module.
Figure 3 schematically illustrates a method for connecting a terminal element to a substrate.
Figure 4 schematically illustrates a continuous wire formed by a plurality of segments.
Figure 5 schematically illustrates one segment of a continuous wire according to embodiments of the disclosure.
Figure 6 schematically illustrates one segment of a continuous wire according to further embodiments of the disclosure.
Figure 7, including Figures 7A to 7E, schematically illustrates a method for connecting a terminal element to a substrate according to embodiments of the disclosure.
Figure 8 schematically illustrates one segment of a continuous wire according to further embodiments of the disclosure.
Figure 9 schematically illustrates one segment of a continuous wire according to even further embodiments of the disclosure.
Figure 10, including Figures 10A to 10E, schematically illustrates a method for connecting a terminal element to a substrate according to further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

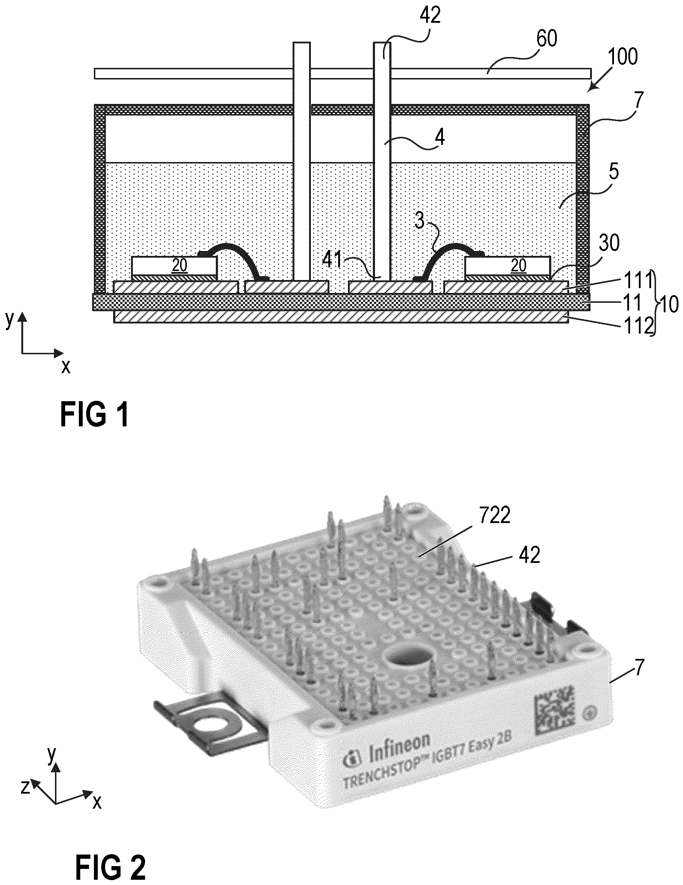

Referring to Figure 1, a cross-sectional view of a power semiconductor module arrangement 100 is schematically illustrated. The power semiconductor module arrangement 100 includes a housing 7 and a semiconductor substrate 10. The semiconductor substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The semiconductor substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin. Generally speaking, any of a number of different substrates might be used as long as they take the form of a structured conductive layer on top of an insulating layer.

The semiconductor substrate 10 is arranged in or below a housing 7. In the example illustrated in Figure 1, the semiconductor substrate 10 forms a ground surface of the housing 7, while the housing 7 itself solely comprises sidewalls and a cover. This, however, is only an example. It is also possible that the housing 7 further comprises a base surface and the semiconductor substrate 10 be arranged on the base surface and inside the housing 7. According to another example, the semiconductor substrate 10 may be mounted on a base plate (not illustrated). In some power semiconductor module arrangements 100, more than one semiconductor substrate 10 is arranged on a single base plate. The base plate may form a ground surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing 7.

One or more semiconductor bodies 20 may be arranged on the semiconductor substrate 10. Each of the semiconductor bodies 20 arranged on the semiconductor substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable electronic element.

The one or more semiconductor bodies 20 may form a semiconductor arrangement on the semiconductor substrate 10. In Figure 1, only two semiconductor bodies 20 are exemplarily illustrated. The second metallization layer 112 of the semiconductor substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using generally known connection technologies, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. For example, the seconds ends 42 of the terminal elements 4 can be connected to a printed circuit board 60. In the example illustrated in Figure 1, a printed circuit board 6 is arranged outside of the housing 7, distant from or in direct contact to, and in parallel to the cover or lid of the housing 7 (and in parallel to the substrate 10). The printed circuit board 60 comprises a plurality of through holes, and each of the plurality of terminal elements 4 protrudes through a different through hole of the plurality of through holes. A plurality of components such as, e.g., semiconductor bodies, or any kind of active or passive components (not specifically illustrated in Figure 1), can be arranged on an external printed circuit board 60. The terminal elements 4 may be used to electrically couple one or more components arranged on the printed circuit board 60 to one or more of the components inside the housing 7.

The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. The terminal elements 4 may be electrically and mechanically connected to the first metallization layer 111 of the semiconductor substrate 10 by an electrically conductive connection layer (not specifically illustrated for the terminal elements 4). Such an electrically conductive connection layer generally may be a solder layer, a layer of an electrically conductive adhesive, or a layer of a sintered metal powder, e.g., a sintered silver powder, for example.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the semiconductor substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the power semiconductor module 100, in particular inside the housing 7, from certain environmental conditions and mechanical damage.

Now referring to Figure 2, a three-dimensional view of a semiconductor module is schematically illustrated. In the example illustrated in Figure 2, the housing 7 comprises a cover which comprises a plurality of through holes 722. Each of the plurality of terminal elements 4 of the semiconductor module extends through a different through hole 722 of the plurality of through holes 722. By providing a plurality of through holes 722 in a housing 7, the housing 7 does not have to be customized, but can be used flexibly by different customers and for different designs. The terminal elements 4, however, have to be positioned accurately on the substrate 10 such that they can be easily inserted into the respective through holes 722 when assembling the semiconductor module. The terminal elements 4 further need to be accurately aligned with through holes provided in an external printed circuit board. Further, in order to be able to assemble the semiconductor module and hold an external printed circuit board 60 in a desired position, the terminal elements 4 need to be sufficiently stable.

On the other hand, it should be possible to attach the terminal elements 4 to the substrate 10 in a swift, reliable, cost-effective and space saving way. Some semiconductor modules are known that comprise hollow rivets attached to the substrate 10. Each of the terminal elements 4 is inserted into a different rivet of the hollow rivets. In particular, the terminal elements 4 are pressed into the respective rivets with a certain amount of force in order to form a reliable and stable connection. Mounting terminal elements 4 to a substrate 10 by means of hollow rivets (pin/rivet connection), however, can be cumbersome. Further, the rivets take up a significant amount of space on the substrate 10 and add to the overall cost of the semiconductor module.

Individual terminal elements 4 can be provided by means of a kind of strap or depot containing a plurality of terminal elements 4 that are separate and distinct from each other. One terminal element 4 may be removed from the strap or depot and may be connected to the substrate 10, e.g., by means of soldering, sintering or welding techniques. The strap or depot and the substrate 10 may then be realigned before removing a next one of the terminal elements 4 and performing a further connection process. This process can be cumbersome and require a significant amount of space.

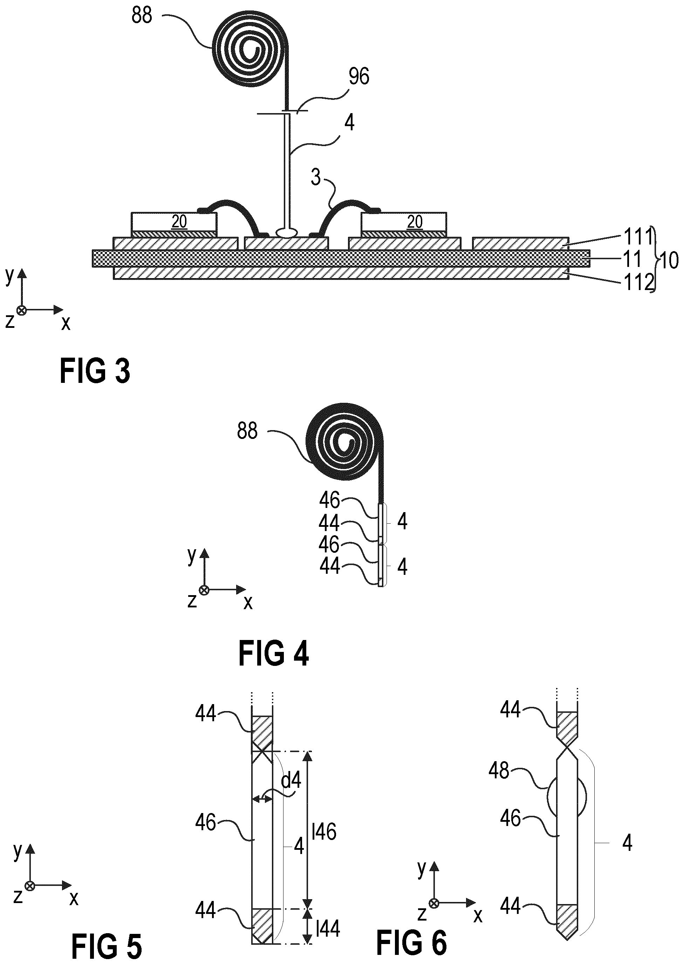

Referring to Figures 3 and 4, terminal elements 4 can alternatively be provided by means of a continuous wire 88. A continuous wire 88 according to embodiments of the disclosure comprises a plurality of segments 4 arranged successively to form the continuous wire 88, wherein each of the plurality of segments 4 comprises a first section 44, and a second section 46 directly adjoining and extending from the first section 44, wherein the second section 46 of each segment 4 further directly adjoins the first section 44 of a directly successive segment 4. In other words, a plurality of first sections 44 and a plurality of second sections 46 are arranged alternatingly along a length of the continuous wire 88. The number of first sections 44 may equal the number of second sections 46. For each of the plurality of segments 4, a hardness of the second section 46 may be greater than a hardness of the first section 44. The first section 44 of each of the plurality of segments 4 is configured to be attached to a substrate 10 of a semiconductor module. When connected to the substrate 10, a segment 4 may be separated from the continuous wire 88, e.g., by means of a cutting tool 96, and form a terminal element of a semiconductor module. As the first section 44 of a segment 4 is comparably soft, it may be connected to the substrate 10 in a swift, reliable, cost-effective and space saving way. When the segment 4 is mounted to a substrate 10 10 and the substrate 10 is arranged in a housing 7, the second section 46 extends through the inside of the housing 7 and to the outside of the housing 7. As the second section 46 is comparably hard and rigid, it can be easily inserted into a through hole 722 in a housing 7 and is solid enough to be connected to a printed circuit board 60 with its second end 42, for example.

Referring to Figure 5, an exemplary segment 4 with its first section 44 and second section 46 is schematically illustrated in further detail. The first section 44 may have a uniform thickness d4 along its entire length l44, and the second section 46 may have a uniform thickness d4 along its entire length l46. It is, however, also possible that the continuous wire 88 comprises a plurality of kerfs, each of the plurality of kerfs being arranged between two directly adjoining segments 4. That is, the first section 44 may have a mostly uniform thickness d4 that decreases towards an end of the first section 44 facing away from the second section 46, and the second section 46 may have a mostly uniform thickness d4 that decreases towards and end of the second section 46 facing away from the first section 44. The kerfs formed between the different segments 4 of the continuous wire 88 allow to easily cut off a segment 4 once it has been connected to a substrate 10. Further, the kerfs allow to clearly identify the end of one segment 4 and the beginning of the next segment.

The length d46 of the second section 46 may be at least twice the length l44, at least five times the length l44, or at least ten times the length l44 of the first section 44. In this way, the major part of the resulting terminal element 4 is rigid and provides sufficient stability. The comparably short first section 44 is merely needed to form a stable connection between the terminal element 4 and the substrate 10. According to one example, the first sections 44 of the plurality of segments 4 consist of a different material than the second sections 46. The material forming the first sections 44 may be comparably soft, as compared to the material forming the second sections 46, for example. According to one example, the second section 46 consists of copper, and the first section 44 consists of a copper alloy having a reduced hardness as compared to pure copper. According to another example, the second section 46 consists of aluminum, and the first section 44 consists of an aluminum alloy having a reduced hardness as compared to pure aluminum. Any other suitable metals or metal alloys can be used instead and can be combined in any suitable way. According to other embodiments, the first section 44 and the second section 46 consist of the same material,, but have different hardnesses as described in further detail below.

The second section 46 of a segment 4 (terminal element), when the segment 4 is arranged on the substrate 10 and has been cut off from the continuous wire 88, may be mechanically and electrically connected to a printed circuit board 60 in any suitable way. For example, the segment 4 may be soldered to a printed circuit board 60. Now referring to Figure 6, the second section 46 of each of the plurality of segments 4 alternatively may comprise a press-fit element 48. The press-fit element 48 is an element that, when inserted into a corresponding counterpart (e.g., through hole through printed circuit board 60), can be compressed to a certain degree (e.g., in a horizontal direction x perpendicular to a length l46 of the second section 46). When compressed, the press-fit element 48 forms a fixed connection to its associated counterpart (e.g., through hole through printed circuit board 60). In this way, a very reliable connection can be formed between a segment 4 (terminal element) and a printed circuit board 60.

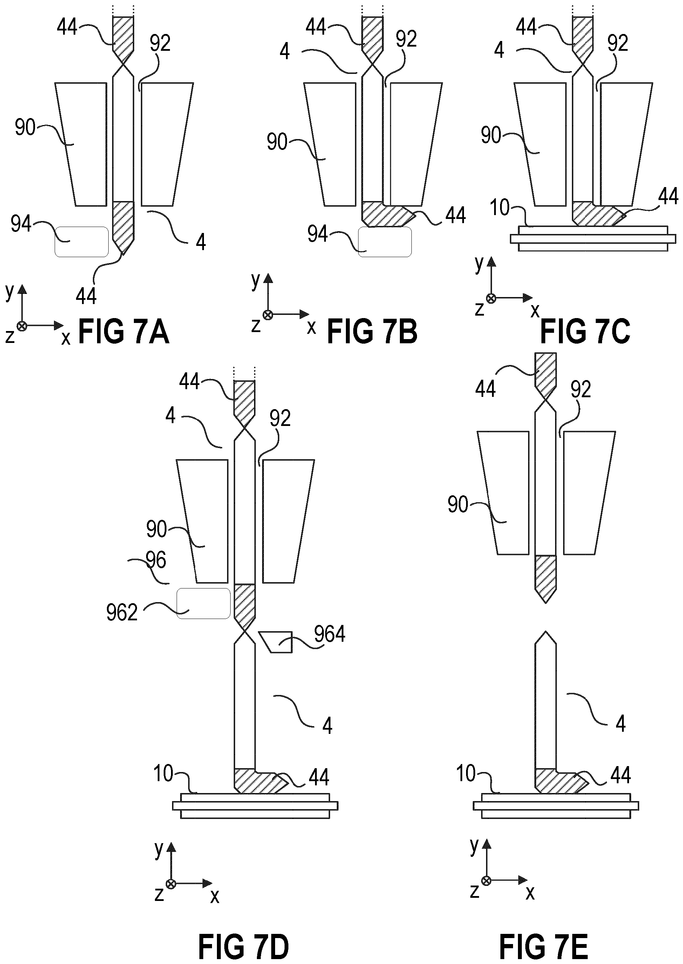

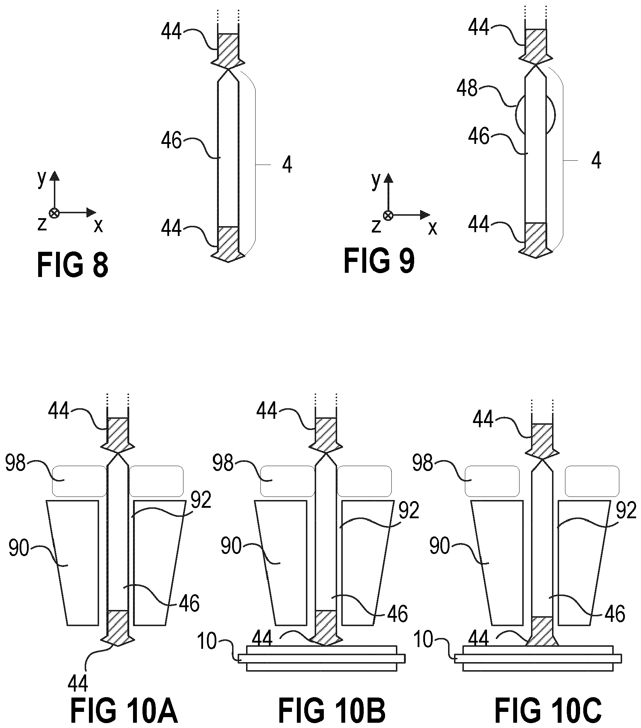

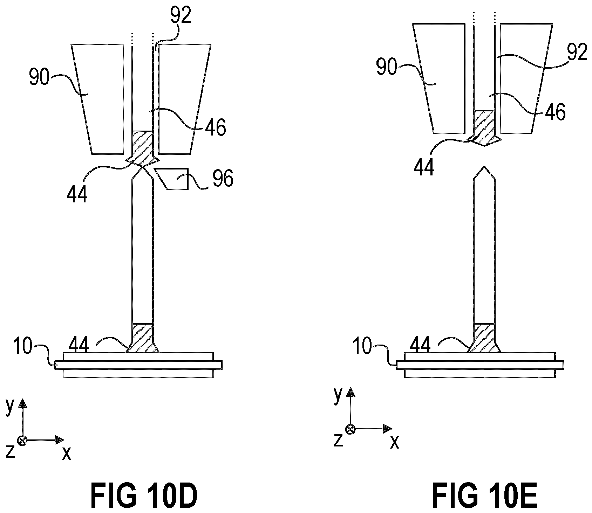

A segment 4 may be welded to a substrate 10, for example, in order to form a reliable connection between the segment 4 and the substrate 10. A system for connecting a terminal element to a substrate 10 according to embodiments of the disclosure comprises a sonotrode 90 with a channel 92 formed therethrough, and a cutting tool 96. This is schematically illustrated in Figures 7A to 7E and 10A to 10E, for example, wherein Figures 7 and 10 illustrate alternative implementations. The system is generally configured to feed a continuous wire 88 comprising a plurality of segments 4 arranged successively to form the continuous wire 88 into a first end of the channel 92 and further through the channel 92 formed in the sonotrode 90 until a first end of the continuous wire 88 protrudes from a second end of the channel 92 opposite the first end of the channel 92 (see, e.g., Figures 7A and 10A). The system is further configured to weld the first end of the continuous wire 88 to a substrate 10 by means of the sonotrode 90 (see, e.g., Figures 7C and 10B), and subsequently cut off a first segment 4 from the continuous wire 88, the first segment 4 comprising a first section 44 comprising the first end, and a second section 46 directly adjoining and extending from the first section 44. At least during the step of welding the first end of the continuous wire 88 to the substrate 10, a hardness of the second section 46 is greater than a hardness of the first section 44. In the figures, the channel 92 is illustrated as extending centrally through the sonotrode 90. This, however, is only an example. The channel 92 generally may extend through the sonotrode 90 at any suitable position, e.g., the channel 92 may also extend along an outside of the sonotrode 90 instead.

As has been described above, the first section 44 may consist of a different material than the second section 46, wherein the material of the second section 46 has a hardness that is greater than a hardness of the material of the first section 44. That is, a hardness of the second sections 46 may be greater than a hardness of the first sections 44 even before the continuous wire 88 is even fed through the channel 92. Alternatively or additionally, the first sections 44 may be heated before being welded to the substrate 10, in order to reduce their hardness. For example, the system may comprise a heating element configured to heat the first section 44 of the first segment 4 while the continuous wire 88 is fed through the channel 92. In this way, the hardness of the first section 44 is reduced before welding it to the substrate 10. According to some examples, the first sections 44 consist of the same material as the second sections 46, and a hardness of the first sections 44 is only reduced by heating the first sections 44 before the welding process is performed. According to other examples, the first sections 44 consist of a different material as the second sections 46, and a hardness of the first sections 44 is additionally reduced by heating the first sections 44 before the welding process is performed. According to even further examples, the first sections 44 consist of a different material as the second sections 46, and no additional steps are performed to reduce the hardness of the first sections 44 before the welding process is performed.

A softened first section 44 may be pressed on the substrate 10 by means of the sonotrode 90 and may be deformed (e.g., compressed) to a certain degree during the welding process. The permanent connection between the segment 4 and the substrate 10 can be considered to form when the first section 44 of the segment 4 subsequently cools down again. The sonotrode 90 may oscillate during the welding process, for example (ultrasonic welding).

The cutting tool 96 (illustrated in Figures 7D and 10D, for example) may be implemented in any suitable way. According to one example, the cutting tool 96 may comprise a cutting edge 964 and a counterholder element 962 (Figure 7D). In this way, a segment 4 that has been mounted on a substrate 10 may be easily cut off the continuous wire 88. Any other suitable implementations, however, are generally also possible. The cutting tool 96 may be configured to cut off the first segment 4 at a kerf formed in the continuous wire 88 between the first segment 4 and a directly adjoining second segment 4.

The diameter d4 of a terminal element 4 may be comparably small (e.g., less than 2 millimeters). When connecting a terminal element 4 having a comparably small diameter d4 to a substrate 10, the resulting connection may be instable and may get damaged during the lifetime of the semiconductor module. Therefore, according to one example and as is schematically illustrated in Figures 7A and 7B, the system may further comprise a bending tool 94 configured to bend the first section 44 after feeding the continuous wire 88 through the channel 92 and before welding the first end of the continuous wire 88 to the substrate 10 such that the first section 44 at least partly extends perpendicular to the second section 46. In this way, the contact area between the segment 4 and the substrate 10 is increased, resulting in a more stable connection. The bending tool 94 may be implemented in any suitable way. In the example illustrated in Figures 7A and 7B, the bending tool 94 merely comprises a simple pressing element that, when the first section 44 protrudes from the channel 92, presses against the first section 44 thereby bending it to a desired position. Alternatively, the counterholder element 962 of the cutting tool 96 may itself force a bending of the first section 44, eliminating a need for a separate bending tool 94.

Bending the first section 44 in order to increase a contact area between the segment 4 and the substrate 120, however, is only an example. Referring to Figures 8 and 9, instead the first section 44 may comprise a cone shaped or T-shaped section. In other words, an end of the first section 44 facing away from the second section 46 may have a locally increased diameter. The diameter d4 of the first section 44 may increase towards its free end before, optionally, decreasing again to form a kerf. Referring to Figures 10B and 10C, when the segment 4 is welded to the substrate 10, the sonotrode 90 generally presses the segment 4, i.e. the first section 44 onto the substrate 10. That is, a normal force is introduced into the substrate 10. When being pressed onto the substrate 10, the free end of the first section 44 deforms, similar to what is illustrated in Figure 10C. That is, even if a diameter of the first section 44 decreases again towards the end facing away from the second section 46 to form a kerf, the end of the first section 44 deforms and is compressed to a certain degree during the welding process, such that the resulting contact surface is comparably large. As is schematically illustrated in Figures 10A and 10B, the system may further comprise a holding element 98 that is configured to securely hold the segment 4 (i.e. the second section 46) during the welding step. The holding element 98 may exert a pressure on the segment 4 or other segments of the continuous wire 88 (e.g., similar to a pair of tongs) in order to prevent it from moving out of a desired position during the welding step (i.e. when the sonotrode 90 vibrates). When the continuous wire 88 is fixed in a position by means of the holding element 98, a force perpendicular to the substrate 10 can be received by the first section 44 which, during the welding process, may be at least partly arranged inside the channel 92 through the sonotrode 90.

Once the connection has been formed and the segment 4 has been cut off from the continuous wire 88, the sonotrode 90 may move to another position with respect to the substrate 10 in order to form a further connection. Instead of or in addition to moving the sonotrode 90, it is also possible that the substrate 10 be moved. According to some examples, the sonotrode 90 merely performs movements in a vertical direction y, and the substrate 10 is realigned with respect to the sonotrode 90 between two subsequent welding processes. A sonotrode 90 being moved vertically away from the substrate 10 is schematically illustrated in Figures 7E and 10E.

A method according to embodiments of the disclosure comprises feeding a continuous wire 88 comprising a plurality of segments 4 arranged successively to form the continuous wire 88 into a first end of a channel 92 and further through the channel 92 formed in a sonotrode 90 of a welding tool until a first end of the continuous wire 88 protrudes from a second end of the channel 92 opposite the first end of the channel 92, welding the first end of the continuous wire 88 to a substrate 10 by means of the sonotrode 90, and cutting off a first segment 4 from the continuous wire 88, the first segment 4 comprising a first section 44 comprising the first end, and a second section 46 directly adjoining and extending from the first section 44, wherein at least during the step of welding the first end of the continuous wire 88 to the substrate 10, a hardness of the second section 46 is greater than a hardness of the first section 44.

The method may further comprise heating the first section 44 of the first segment 4 while feeding the continuous wire 88 through the channel 92, thereby decreasing the hardness of the first section 44. Alternatively, the wire may be heated before placement into the channel 92, and may even be produced with hardened sections during manufacture of the continuous wire 88. Additionally or alternatively, the method may further comprise bending the first section 44 after feeding the continuous wire 88 through the channel 92 and before welding the first end of the continuous wire 88 to the substrate 10 such that the first section 44 at least partly extends perpendicular to the second section 46. Cutting off the first segment 4 from the continuous wire 88 may comprise cutting off the first segment 4 at a kerf formed in the continuous wire 88 between the first segment 4 and a directly adjoining second segment 4. Instead of bending the first section 44, the first section 44 of the first segment 4 may further comprise a cone shaped or T-shaped section forming the first end of the continuous wire 88, and wherein welding the first end of the continuous wire 88 to the substrate 10 may comprise welding the cone shaped or T-shaped section to the substrate 10.

## Claims

1. A method comprises:
feeding a continuous wire (88) comprising a plurality of segments (4) arranged successively to form the continuous wire (88) into a first end of a channel (92) and further through the channel (92) formed in a sonotrode (90) of a welding tool until a first end of the continuous wire (88) protrudes from a second end of the channel (92) opposite the first end of the channel (92);
welding the first end of the continuous wire (88) to a substrate (10) by means of the sonotrode (90); and
cutting off a first segment (4) from the continuous wire (88), the first segment (4) comprising a first section (44) comprising the first end, and a second section (46) directly adjoining and extending from the first section (44), wherein
at least during the step of welding the first end of the continuous wire (88) to the substrate (10), a hardness of the second section (46) is greater than a hardness of the first section (44).

2. The method of claim 1, further comprising heating the first section (44) of the first segment (4) while feeding the continuous wire (88) through the channel (92), thereby decreasing the hardness of the first section (44).

3. The method of claim 1 or 2, further comprising bending the first section (44) after feeding the continuous wire (88) through the channel (92) and before welding the first end of the continuous wire (88) to the substrate (10) such that the first section (44) at least partly extends perpendicular to the second section (46).

4. The method of any of claims 1 to 3, wherein cutting off the first segment (4) from the continuous wire (88) comprises cutting off the first segment (4) at a kerf formed in the continuous wire (88) between the first segment (4) and a directly adjoining second segment (4).

5. The method of claim 1 or 2, wherein the first section (44) of the first segment (4) further comprises a cone shaped or T-shaped section forming the first end of the continuous wire (88), and wherein welding the first end of the continuous wire (88) to the substrate (10) comprises welding the cone shaped or T-shaped section to the substrate (10).

6. A system for connecting a terminal element to a substrate (10) comprises a sonotrode (90) with a channel (92) formed therethrough; and
a cutting tool (96), wherein
the system is configured to feed a continuous wire (88) comprising a plurality of segments (4) arranged successively to form the continuous wire (88) into a first end of the channel (92) and further through the channel (92) formed in the sonotrode (90) until a first end of the continuous wire (88) protrudes from a second end of the channel (92) opposite the first end of the channel (92);
weld the first end of the continuous wire (88) to a substrate (10) by means of the sonotrode (90); and
cut off a first segment (4) from the continuous wire (88), the first segment (4) comprising a first section (44) comprising the first end, and a second section (46) directly adjoining and extending from the first section (44), wherein
at least during the step of welding the first end of the continuous wire (88) to the
substrate (10), a hardness of the second section (46) is greater than a hardness of the first section (44).

7. The system of claim 6, further comprising
a heating element configured to heat the first section (44) of the first segment (4) while the continuous wire (88) is fed through the channel (92), thereby decreasing the hardness of the first section (44).

8. The system of claim 6 or 7, further comprising
a bending tool (94) configured to bend the first section (44) after feeding the continuous wire (88) through the channel (92) and before welding the first end of the continuous wire (88) to the substrate (10) such that the first section (44) at least partly extends perpendicular to the second section (46).

9. The system of any of claims 6 to 8, wherein the cutting tool (96) is configured to cut off the first segment (4) at a kerf formed in the continuous wire (88) between the first segment (4) and a directly adjoining second segment (4).

10. A continuous wire (88) comprises a plurality of segments (4) arranged successively to form the continuous wire (88), wherein
each of the plurality of segments (4) comprises a first section (44) and a second section (46) directly adjoining and extending from the first section (44), wherein the second section (46) of each segment (4) further directly adjoins the first section (44) of a directly successive segment (4),
for each of the plurality of segments (4), a hardness of the second section (46) is greater than a hardness of the first section (44), and
the first section (44) of each of the plurality of segments (4) is configured to be attached to a substrate (10) of a semiconductor module.

11. The continuous wire (88) of claim 10, further comprising a plurality of kerfs, each of the plurality of kerfs being arranged between two directly adjoining segments (4).

12. The continuous wire (88) of claim 10 or 11, wherein the first sections (44) of the plurality of segments (4) consist of a different material than the second sections (46).

13. The continuous wire (88) of any of claims 10 to 12, wherein the first section (44) of each segment (4) of the plurality of segments (4) comprises a cone shaped or T-shaped section.

14. The continuous wire (88) of any of claims 10 to 13, wherein the second section (46) of each segment (4) of the plurality of segments (4) comprises a press-fit element (48).

## Amended claims

### Amended claims in accordance with Rule 137(2) EPC.

1. A method comprises:
feeding a continuous wire (88) comprising a plurality of segments (4) arranged successively to form the continuous wire (88) into a first end of a channel (92) and further through the channel (92) formed in a sonotrode (90) of a welding tool until a first end of the continuous wire (88) protrudes from a second end of the channel (92) opposite the first end of the channel (92);
welding the first end of the continuous wire (88) to a substrate (10) by means of the sonotrode (90); and
cutting off a first segment (4) from the continuous wire (88), the first segment (4) comprising a first section (44) comprising the first end, and a second section (46) directly adjoining and extending from the first section (44), wherein
at least during the step of welding the first end of the continuous wire (88) to the substrate (10), a hardness of the second section (46) is greater than a hardness of the first section (44).

2. The method of claim 1, further comprising heating the first section (44) of the first segment (4) while feeding the continuous wire (88) through the channel (92), thereby decreasing the hardness of the first section (44).

3. The method of claim 1 or 2, further comprising bending the first section (44) after feeding the continuous wire (88) through the channel (92) and before welding the first end of the continuous wire (88) to the substrate (10) such that the first section (44) at least partly extends perpendicular to the second section (46).

4. The method of any of claims 1 to 3, wherein cutting off the first segment (4) from the continuous wire (88) comprises cutting off the first segment (4) at a kerf formed in the continuous wire (88) between the first segment (4) and a directly adjoining second segment (4).

5. The method of claim 1 or 2, wherein the first section (44) of the first segment (4) further comprises a cone shaped or T-shaped section forming the first end of the continuous wire (88), and wherein welding the first end of the continuous wire (88) to the substrate (10) comprises welding the cone shaped or T-shaped section to the substrate (10).

6. A system for connecting a terminal element to a substrate (10) comprises a sonotrode (90) with a channel (92) formed therethrough; and
a cutting tool (96), wherein
the system is configured to feed a continuous wire (88) comprising a plurality of segments (4) arranged successively to form the continuous wire (88) into a first end of the channel (92) and further through the channel (92) formed in the sonotrode (90) until a first end of the continuous wire (88) protrudes from a second end of the channel (92) opposite the first end of the channel (92);
weld the first end of the continuous wire (88) to a substrate (10) by means of the sonotrode (90); and
cut off a first segment (4) from the continuous wire (88), the first segment (4) comprising a first section (44) comprising the first end, and a second section (46) directly adjoining and extending from the first section (44), wherein
at least during the step of welding the first end of the continuous wire (88) to the
substrate (10), a hardness of the second section (46) is greater than a hardness of the first section (44).

7. The system of claim 6, further comprising
a heating element configured to heat the first section (44) of the first segment (4) while the continuous wire (88) is fed through the channel (92), thereby decreasing the hardness of the first section (44).

8. The system of claim 6 or 7, further comprising
a bending tool (94) configured to bend the first section (44) after feeding the continuous wire (88) through the channel (92) and before welding the first end of the continuous wire (88) to the substrate (10) such that the first section (44) at least partly extends perpendicular to the second section (46).

9. The system of any of claims 6 to 8, wherein the cutting tool (96) is configured to cut off the first segment (4) at a kerf formed in the continuous wire (88) between the first segment (4) and a directly adjoining second segment (4).

10. A continuous wire (88) comprises a plurality of segments (4) arranged successively to form the continuous wire (88), each segment (4) of the plurality of segments (4) being configured to form a terminal element of a semiconductor module, wherein
each of the plurality of segments (4) comprises a first section (44) and a second section (46) directly adjoining and extending from the first section (44), wherein the second section (46) of each segment (4) further directly adjoins the first section (44) of a directly successive segment (4),
for each of the plurality of segments (4), a hardness of the second section (46) is greater than a hardness of the first section (44), and
the first section (44) of each of the plurality of segments (4) is configured to be attached to a substrate (10) of a semiconductor module.

11. The continuous wire (88) of claim 10, further comprising a plurality of kerfs, each of the plurality of kerfs being arranged between two directly adjoining segments (4).

12. The continuous wire (88) of claim 10 or 11, wherein the first sections (44) of the plurality of segments (4) consist of a different material than the second sections (46).

13. The continuous wire (88) of any of claims 10 to 12, wherein the first section (44) of each segment (4) of the plurality of segments (4) comprises a cone shaped or T-shaped section.

14. The continuous wire (88) of any of claims 10 to 13, wherein the second section (46) of each segment (4) of the plurality of segments (4) comprises a press-fit element (48).
